# EUROPEAN PATENT SPECIFICATION

(11) **EP 2 376 902 B1**
(45) Date of publication and mention of the grant of the patent: **25.06.2014**
(21) Application number: 08875521.0
(22) Date of filing: 22.12.2008
(51) Int. Cl.: G01N 24/08, B65G 21/10, B65G 21/20, G01R 33/38, G01R 33/383, G01R 33/563

(54) **LAYER ON-LINE MEASUREMENT WITH NMR**
ON-LINE-SCHICHTMESSUNG MIT NMR
MESURE EN LIGNE DE COUCHES PAR RMN

(43) Date of publication of application: 19.10.2011
(73) Proprietor: Pirelli Tyre S.P.A., 20126 Milan (IT)
(72) Inventor: HOCK, Bernd, 63762 Gross-Ostheim (DE); ALBOHR, Oliver, 64739 Höchst (DE); KUHLMANN, Udo, 63741 Aschaffenburg (DE); GARRO, Luciano, 20126 Milano (IT)
(74) Representative: Preissner, Nicolaus
(86) International application number: PCT/EP2008/068206
(87) International publication number: WO 2010/072255

(56) References cited:
- EP-A1- 0 313 435
- US-A- 5 128 077
- US-A1- 2001 051 550
- GREEN M A; BARALE P J; FONG C G; LUFT P A; REIMER J A; YAHNKE M S: "Magnet options for sensors for the pulp and paper industry" AIP CONFERENCE PROCEEDINGS AIP USA, no. 613B, 2002, pages 1628-1635, XP002543584 ISSN: 0094-243X
- COATES P D; BARNES S E; SIBLEY M G; BROWN E C; EDWARDS H G M; SCOWEN I J: "In-process vibrational spectroscopy and ultrasound measurements in polymer melt extrusion" POLYMER 20030821 ELSEVIER LTD GB, vol. 44, no. 19, 21 August 2003 (2003-08-21), pages 5937-5949, XP004447630
- GOTTWALD A; SCHELER U: "Extrusion monitoring of polymer melts using a high-temperature surface-NMR probe" MACROMOLECULAR MATERIALS AND ENGINEERING 20050523 WILEY-VCH VERLAG DE, vol. 290, no. 5, 23 May 2005 (2005-05-23), pages 438-442, XP002543585 cited in the application
- BLÜMICH B: "NMR Imaging of Materials passage" NMR IMAGING OF MATERIALS, CLARENDON PRESS, OXFORD, GB, 1 January 2000 (2000-01-01), pages 415-423,439, XP002379411
- PERLO J; CASANOVA F; BLUEMICH B: "Ex situ NMR in highly homogeneous fields: <1>H spectroscopy" SCIENCE, AMERICAN ASSOCIATION FOR THE ADVANCEMENT OF SCIENCE, US, WASHINGTON, DC, vol. 315, no. 5815, 23 February 2007 (2007-02-23), pages 1110-1112, XP002437076 ISSN: 0036-8075

## Description

### Background of the Invention

The present invention concerns a method for controlling the production of a moving multi-component product exiting from a manufacturing apparatus. The product is made of an elastomeric material and has layers of different thickness. The thickness of the layers composing the product is determined by means of an NMR-sensor. Furthermore the present invention concerns an apparatus for controlling the production of such a moving composite product.

The term elastomeric material as used in the present patent application encompasses natural and synthetic elastomers, as well as thermoplastic elastomers (TPE).

In the production of tires a tread strip is used which is a composite rubber product comprising several layers of different thickness, layer geometries and material. Such a composite product is usually continuously produced by means of a multi-component extruder. The speed of the extruded product coming from the extruder is approximately 30 m/min and the temperature about 140 °C. The thickness, geometry and material of the layers of the tire strip are important for quality reasons.

Currently, the thickness of the individual layers of the composite product is measured by taking a sample at the end of the production line. The sample has to be cut in a 90° angle in x-direction and is measured optically. This involves the disadvantages of a low accuracy, a measuring time of about one minute per measuring point and, if the tolerance is not met, the production of scrap material.

In US 5,128,077 a method for producing a multi-component extrudate is described in which the operating line automatically extrudes the extrudate materials to obtain the desired contribution of materials and specified dimensions of the profile. The measurement of the thicknesses and width of the extrusion profile is carried out by a pneumatic, non-contacting sensor, which measures the outer dimensions of the extrudate. The measuring signal is used for a closed loop control of the screw speeds of the extruders.

In EP 0 733 457 B a mufti-component extruder for producing multi-component profiles is disclosed. The outer dimensions of the tread strip are measured by means of cameras connected with a control unit for controlling the extruders.

In Gottwald, Antje; Scheler, Ulrich "Extrusion Monitoring of Polymer Melts using a High-Temperature Surface-NMR-Probe", Macromol. Material and Engineering, v 290, May 23, 2005, page 438-442 a surface NMR (Nuclear Magnetic Resonance) is used for monitoring of hot extruded polymer melts. The NMR-sensor is arranged below the moving extrudate coming from the extruder. By means of a lift table the distance between the sample and the NMR-MOUSE can be adjusted.

In US 2002/0084783 A1 an apparatus for examining flat goods of polymeric material is described having textile reinforcement structures embedded therein. The apparatus comprises three NMR-Mouse probes arranged in ring planes in the direction of a cylinder axis.

M.A. Green et al, "Magnet Options for Sensors for the Pulp and Paper Industry" AIPConference Proceedings , no. 613, 2002, pages 1628-1635 disclooses use of the total thickness of a moving paper sheet by NMR measurement.

EP 0 313 435 A 1 discloses a method for controlling the producting of an elastomeric material which is exiting from a manufacturing apparatus. NMR measurement is carried out to continously control the material quality of the product. The measuring values are compared with known values.

### Summary of the invention

In order to provide tires being able to provide the required performances in a repeatable way, the quality of the semi-finished products to be assembled to make the tires should be precisely controlled. This particularly applies to semi-finished products made by a plurality of layers, such as, e.g., a tread band, which is often made by a multi-component layered so-called "cap and base" structure comprising a thick layer being destined to the contact with the road, an underlayer typically provided for improving the performance of the tire, and, possibly, a thin further layer provided for improving adhesion with the under-lying belt structure.

In more detail, an out-of-specification in the thickness of the different layers in the multi-component semi-finished product may cause an out-of-specification of the whole product. Sometimes, it may occur that two out-of-specification in the thickness of two layers may geometrically cancel with each other, so that the overall geometry of the multi-component product is maintained, but with wrong thickness distribution. This causes a variation in the features of the whole product, and, at the very end, of the finished tire.

Moreover, sometimes out-of-specification in the compound comprised in a semi-finished product may occur. This also causes a variation in the features of the semi-finished product, and, at the very end, of the finished tire.

The invention provides a solution to the problem of providing a method and an apparatus by which the thickness and the material of a plurality of layers of a moving product made of an elastomeric material (such as an extruded tread band of a tyre) can be continuously and precisely measured.

More particularly, the invention provides a solution to the problem of providing a method and an apparatus by which the thickness and the material of a plurality of layers of a moving product made of an elastomeric material (such as an extruded tread band of a tyre) can be continuously and precisely meas ured under hot conditions, i.e. quite close to the output of an apparatus provided for producing the composite product, so as to promptly react and control the production apparatus as soon as an out-of-specification thickness should occur.

It has been found that such problem can be solved by a method comprising the steps of:
a) performing an NMR measurement of the moving product by positioning a measuring device below the moving product including an NMR sensor comprising a temperature resistant permanent magnet and providing a magnetic field B₀ with a substantially constant gradient Go in the y-axis;
b) determining the thickness of each of the layers based on the NMR measurement;
c) adjusting at least one operating parameter of said manufacturing apparatus based the thickness of each of the layers determined in step b).

By means of this method, the thickness of the layers of the moving multi-component product made of an elastomeric material can be precisely determined during production i.e. under hot conditions and the manufacturing apparatus i.e. a multi-component extruder can be controlled based on these measuring values.

In a further aspect, the invention relates to an apparatus for the production of a moving multi-component product exiting from the apparatus in a moving direction defining an x-axis, the moving multi-component product being made of an elastomeric material and having layers stacked on each other in a y-axis perpendicular to the x-axis, wherein each layer has of different thickness, said apparatus comprising:
a) an output for the product ;
b) a measuring device comprising an NMR-sensor arranged to generate NMR-signals, located close after the output and below said product during use,
c) the NMR sensor comprising a temperature resistant permanent magnet and providing a defined magnetic field B₀ with a substantially constant gradient Go in the y-axis; and
d) the measuring device being arranged to determine the thickness of each of the layers based on said NMK signals.

The invention uses a special magnetic field provided by the NMR sensor which allows measuring the layers of the product in motion and in hot condition. The magnetic field is characterised by a defined magnetic field B₀ with a substantially constant gradient Go in the y-axis (i.e. an axis orthogonal to the moving composite product) and a substantially constant magnetic field in the z-x plane (i.e. the plane on which the moving composite product lies during the measurement). The NMR sensor applies pulse sequences to the product.

The strength and the geometry of the magnetic field makes it possible to carry out the measurement without repetition in one scan (one shot) and to receive depth profiles of the product up to 5 mm with an accuracy up to +/-0.025 mm. During measuring the distance between the NMR sensor and the product is kept constant in the y-axis.

The composite product can be produced in different ways e.g. by means of an extruder, calender, gear-pump process or injectors.

The measuring methods according to the invention can be carried out close to the production line e.g. close to the die head of an extruder. Thus, deviations from the target value can be quickly adjusted with a very limited waste of out-of-specification extruded product.

Other features and advantages of the present invention will become apparent from the following more detailed description of the embodiments, which describe, by way of example, the principles of the invention.

### Brief Description of the Drawings

- Fig. 1: is a schematic side view of an operating line for manufacturing a multi-component product and a measuring device according to the invention;
- Fig. 2: shows a schematic enlarged view of a portion of the operating line of figure 1 in the zone of the measuring device;
- Fig. 3a-3d: show schematic cross-sectional views of different exemplary extrusion profile portions;
- Fig. 4: is a schematic side view of a NMR-sensor used in the present invention;
- Fig. 5: is a schematic top-plan view of the NMR-sensor according to Fig. 4;
- Fig. 6: is a graph showing an exemplary distribution of the magnetic field produced by the NMR-sensor of figures 4-5 in the z-y plane;
- Fig. 7: is a graph showing an exemplary distribution of the magnetic field produced by the NMR-sensor of figures 4-5 in the x-y plane;
- Fig. 8: is a flow-chart of an exemplary method for determining the thickness of the layers of the product;
- Fig. 9: is a graph showing exemplary measured layer thicknesses; and
- Fig. 10: shows a flow-chart of an exemplary method for determining the material of a rubber layer of the product.

### Detailed Description of the Invention

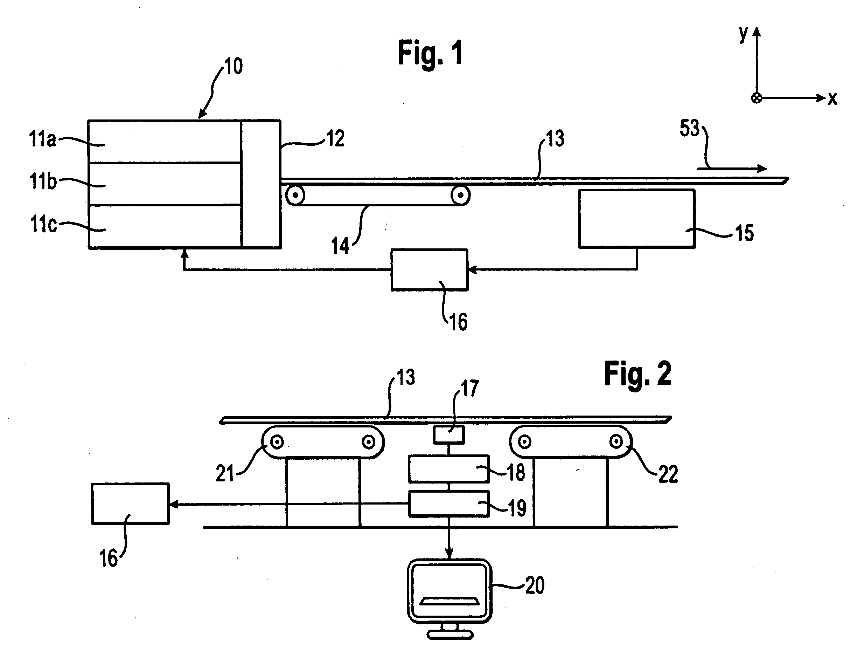

Fig. 1 schematically shows an operating line for manufacturing a multicomponent product 13 such as an extruded tread strip for use in a vehicle tire. It is noticed that the present invention also applies to products manufactured by other rubber processing methods such as calendering, gear-pump process, injectors.

The operating line includes a multi-component extruder 10 comprising individual extruders 11a, 11b, 11c. Each extruder 11a, 11b, 11c has a screw (not-shown) which turns at an individual screw speed controlled by means of a control device 16. The extruders 11 a, 11 b, 11c can be fed by different rubber materials, in particular different rubber compositions. A die 12 is connected with the exit of the extruders 11 a, 11 b, 11c. The product 13 coming from the die 12 is supported by means of a conveyor belt 14.

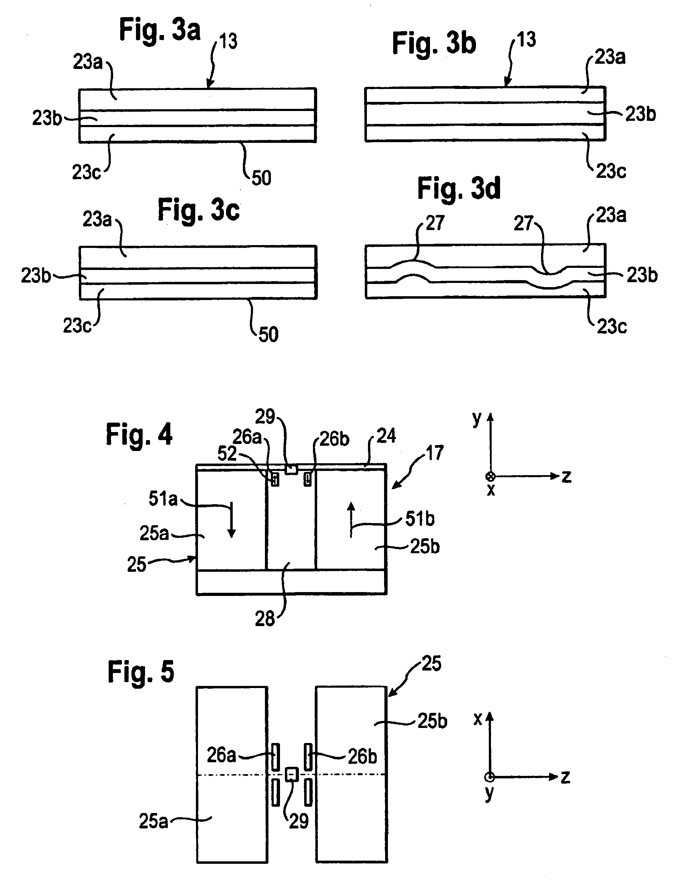

The product 13 is driven by the conveyor belt 14 in the direction of arrow 53 at a speed of approximately 20 to 30 m/min. The product 13 has a temperature of about 120 °C close to the output of the die 12. As can be taken from Fig. 3a to 3d the product 13 comprises three layers 23a, 23b, 23c of different thicknesses and material. Fig. 3a and Fig. 3c show possible target values of the thicknesses for the layers 23a, 23b, 23c. Although the outer overall dimensions of the product 13 shown in Fig. 3b are the same as in Fig. 3a, the thicknesses of the individual layers 23a, 23b, 23c are different.

Fig. 3d shows that although the total thickness of the layers 23a, 23b, 23c is the same as in Fig. 3c, geometrical deviations 27 can occur.

To monitor the quality and to control the multi-component extruder 10 in or-der to keep the variation of the layer-geometries within the acceptable toler-ances, a measuring device 15 is arranged close after the extrusion die 12. As can be taken from Fig. 1, the measuring signal of the measuring device 15 can be supplied to the control device 16 which controls the individual extruders 11 a, 11 b, 11c of the multi-component extruder 10. Thus, in case a thickness being out-of-specification is detected, at least one of the operating parameters (typically the screw speed) of the relevant individual extruder 11a, 11 b, 11c is adjusted. Figure 1 shows an "online" automatic adjustment based on the measurement performed by the measuring device 15. However, the adjustment of the at least one operating parameter of the extruders 11a, 11b, 11 c can be performed "offline" by an operator, based on the results measured by the measuring device 15.

An exemplary construction of the measuring device 15 is shown in Fig. 2. The measuring device 15 comprises an NMR-sensor 17 which will be described in detail in connection with Figs. 4 and 5. The NMR-sensor 17 is connected with a spectrometer 18 and a computer 19. The output of the computer 19 is connected with the control device 16 and/or with a display 20.

To obtain 2-d measurements the NMR-sensor 17 can be positioned in the lateral direction with respect to the product flow.
The moving product 13 coming from the extrusion die 12 is supported by conveyor belts 21, 22 during the measurement performed by the NMR-sensor 17.

Fig. 4 shows a schematic side view and Fig. 5 a top plan view of an exemplary embodiment of the NMR-sensor 17 which comprises a permanent magnet 25 with magnetic poles 25a, 25b. The permanent magnet 25 is made of a samarium cobalt alloy in order to fulfil the requirement to work at a high temperature. The magnetic polarisation of the permanent magnet 25 is indicated by arrows 51a, 51 b in Fig. 4. The product 13 is moved in x-direction with respect to the NMR-sensor 17.

In the preferred embodiment of figure 4-5, the permanent magnet 25 delimits a gap 28 in which shim units 26a, 26b are arranged for precision tailoring of the magnetic field. The shim units 26a, 26b are preferably embedded in an epoxy resin. The shim units 26a, 26b may comprise rectangular magnetic blocks made from a samarium cobalt alloy with a magnetic polarisation direction as shown in Fig. 4. The polarisation of the shim units 26a, 26b is indicated by arrows 52 in Fig.4.

A coil 29, preferably of square shape, is also arranged between the shim units 26a, 26b. The coil 29 generates a B₁ rf field.

In an exemplary embodiment, the permanent magnet 25 has the following properties:
Material: Sm₂Co₁₇
Magnetic field strength B₀: 0.250 T
Gradient Go: 1.2 T/m
Remanence: 1.05-1.08 T
Coercivity force: 756-796 KA/m
Intrinsic coercivity force: 1433-1831 KA/m
Max. energy product: 205-220 HJ/m³
Max. operating temperature: 300°C
Temperature coefficient of remanence: -0.03 %/°C
Density: 8.3-8.5 g/cm³
Vickers Hardness: 500-600

The magnetic field of the NMR-sensor 17 is characterised by a well-defined magnetic field B₀ with a strong, substantially constant gradient Go in the y-axis and a substantially constant magnetic field in the z-x plane. The gradient Go has a value of about 1.0 T/m to 1.4 T/m preferably 1.2 T/m. The magnetic field B₀ has a value of about 0.250 to 0.254 T. The strength and the geometry of the magnetic field makes it possible to carry out the measurement without repetition in one scan (one shot) and to receive depth profiles of the product up to 5 mm with an accuracy up to +/- 0.025 mm. During the measurement the process distance between the NMR-sensor and the product is kept as most as possible constant in the y-axis.

The permanent magnet 25 is covered by a sliding plate 24 which is made of an NMR transparent material such as polyetheretherketone (PEEK). The coil 29 is embedded in a recess provided in the sliding plate 24.

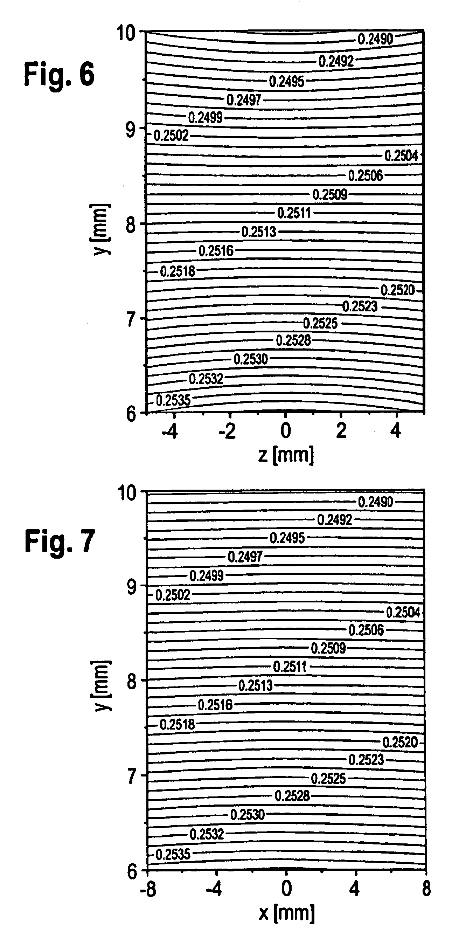

Fig. 6 shows an exemplary distribution of the magnetic field generated by the NMR sensor in the z-y plane, which is indicated in Fig. 4 and 5. The magnetic field strength is measured in Tesla.

Fig. 7 shows an exemplary distribution of the magnetic field generated by the NMR sensor in the x-y plane, which is indicated in Fig. 4 and 5. The magnetic field strength is measured in Tesla.

As will be described in detail below, the measuring methods according to the present invention allow the thickness of each layer 23a, 23b, 23c to be determined with very high precision. Moreover, the identification of the material of the same can also be performed.

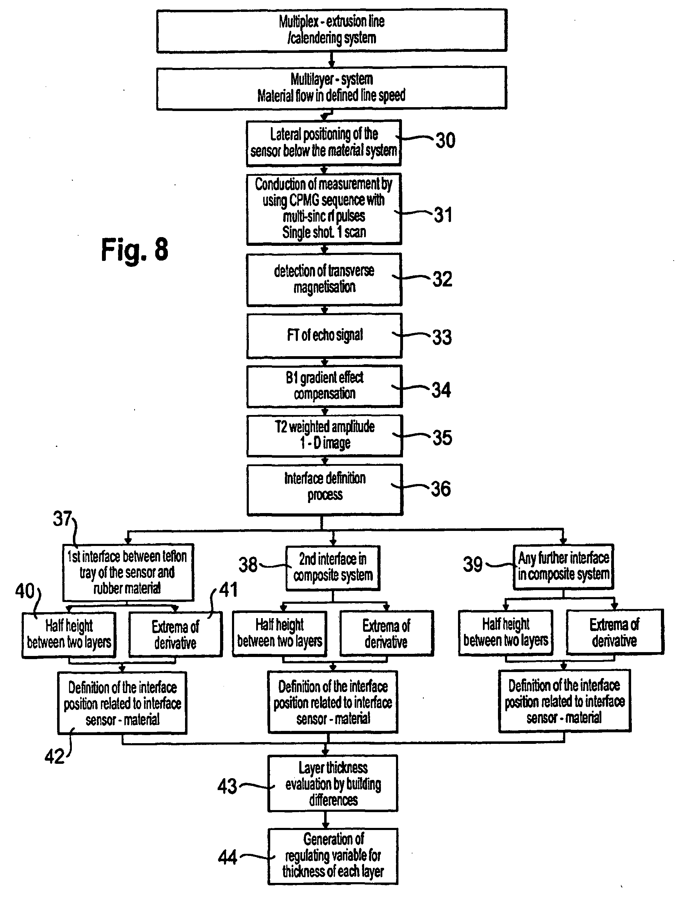

Fig. 8 illustrates an exemplary flow-chart for a method for determining the thickness of the rubber layers 23a, 23b, 23c of the product 13 produced by the multi-component extruder 10.

The multi-layer product, coming out from the multiplex-extrusion line (or other line), flows at a defined line speed.

In step 30 the NMR-sensor 17 is positioned in the lateral direction with regard to the product flow 53 below the moving product 13.

In step 31 a CPMG sequence comprising multi-sinc rf pulses is applied in a single shot to the product 13. The frequency of the rf pulses is about 10.85 MHZ +/- 0.05. Due to the product speed of up to 30 m/min a very short measuring time of about 50 to 100 msec is required in order to concentrate the measuring area to a minimum diagonal of the length of the product 13. One scan is sufficient.

Step 32 illustrates a detection of the transverse magnetisation M of the multi-echo signals (multi echo, about 128 echoes).

The echo signals are then Fourier-transformed (FT) to obtain the NMR spectrum (or 1 D-image) as illustrated in step 33.

Afterwards, in step 34 the B1-gradient effect is compensated in 1 D-images by linear masking.

In step 35 from the set (- 128) of 1D- images two results are built. A 1 D-image proportional to ¹H density (density image) calculated from the detected echo signals and a second image calculated (T₂ image) as the addition of late detected echoes (strongly influenced by T₂) divided by early detected ones.

In step 36 the interface definition process starts.

In step 37, the reference interface between the NMR-sensor 17 and the outside lower surface of the product is determined. In the following step 38 the second interface in the composite product 13 is determined. Further interfaces in the composite system are determined in step 39. In determining the interfaces according to steps 37, 38, 39 either the half height method between two layers (step 40) or the extreme of the derivative (step 41) can be used. Afterwards, in step 42, a definition of the interface position related to the interface sensor-material is carried out.

Each of the layers 23a, 23b, 23c is assumed to have a given amplitude that is different from the next layer. The half height method search for a point with an amplitude (a1 + a2)/2 or the extreme of the derivate means to search for the central position of the peaks obtained. The method is applied to the two results of step 35, density image and T₂ image. The position of the interfaces is then determined from one, the other, or a combination of both depending of the layer composition.

In step 43, the layer thickness is evaluated by building differences. The difference between consecutive interfaces is the thickness of the layer. For example, the interface A is at 1.5 mm depth, the interface B at 2.00 mm depth, the thickness of the layer is then 0.5 mm.

If the measuring signal is used for controlling the multi-component extruder 10, a regulating variable for adjusting at least one operating parameter thereof (e.g. the speed of an extruder screw) is generated in step 44, in case at least one of the layer thicknesses is found to be out-of-specification.

By means of the measuring method as described above the thicknesses of the single layers 23a, 23b, 23c can be determined. The measurement can be carried out on-line for the product 13 which can have a speed of up to 30 m/min and maximum reachable temperature of about 140 °C. By means of the NMR-technology used in the measuring method, the product 13 can be measured in motion and under hot conditions in one scan (single shot).

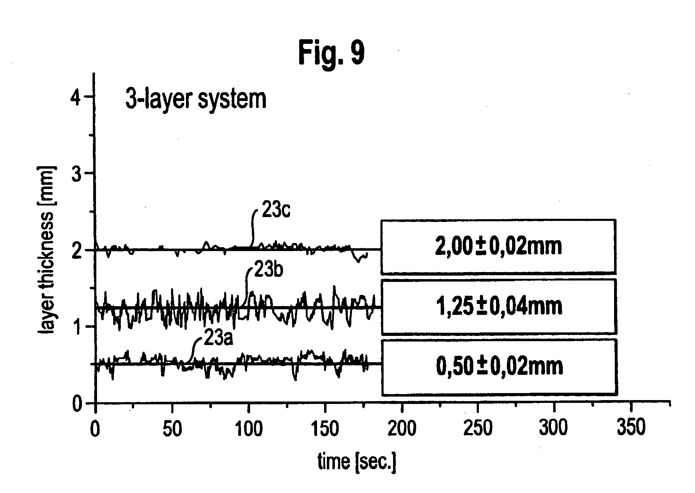

Fig. 9 illustrates a graph which shows the layer thicknesses of all of the layers 23a, 23b, 23c as determined for an exemplary tread band product. As can be seen, the thickness of the first layer 23a is 0.50 mm. The second layer 23b has a thickness of 1.25 mm and the thickness of the third layer 23c of 2.00 mm. It is important to notice that the accuracy of the NMR method allows the detection of an out-of-specification value with a very high precision: in particular, as it can be seen in figure 9, tolerances of less than 0.05 mm are obtained.

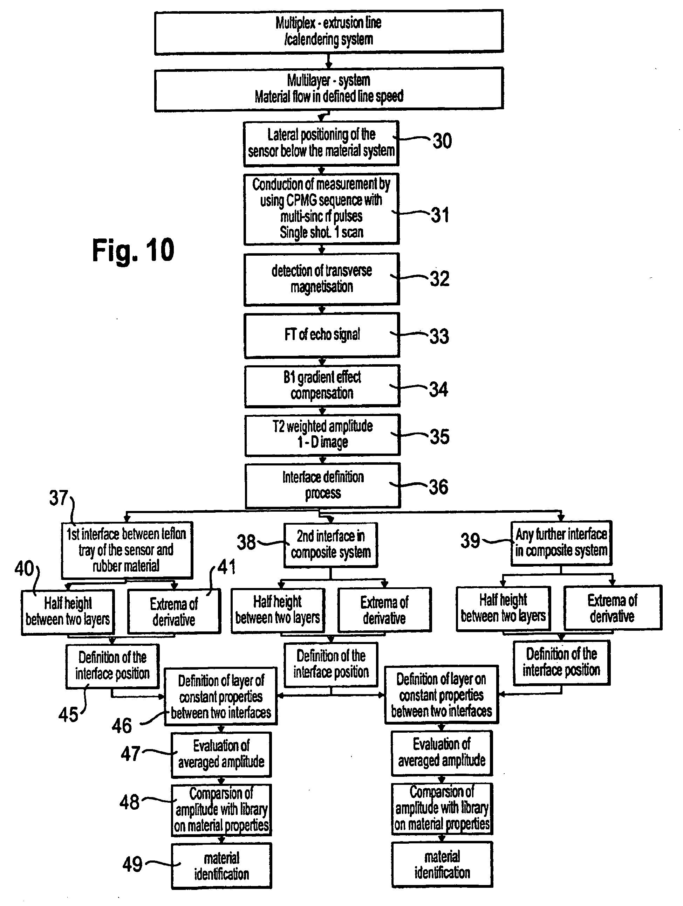

Fig. 10 illustrates an exemplary flow-chart of a method for determining the material of the rubber layers 23a, 23b, 23c of the product 13.

As can be seen, steps 30 to 40 of the measuring method for determining the thicknesses of the layers 23a, 23b, 23c according to Fig. 6 are also used in the method for determining the materials of the layers 23a, 23b, 23c.
After step 40 or step 41 the interface position is defined in step 45. In step 46 a layer of constant magnetic properties between two interfaces is defined.
In step 47, the evaluation of the average values of the density image and T₂ image (result in step 35) of each layer 23a, 23b. 23c is carried out.

A comparison of the ¹H density and T₂ image with a library of NMR properties is carried out in step 48 the result of which provides the material identification as illustrated in step 49.

A regulating variable for the material of each layer can be generated to control the multi-component extruder 10.
As described above, the measuring methods make use of NMR measurement. The on-line measurement can be carried out for a product which moves up to about 30 m/min and have a temperature up to about 140 °C. This is achieved by means of a high-temperature resistant NMR-sensor 17.

The above measuring methods make it possible to detect with high accuracy possible deviations from the target values of the thickness of the different layers. This allows a very quick intervention for controlling the extrusion parameters in case of an out-of-specification thickness, with the advantageous result of a low waste of product, since the measurements can be carried out close to the exit of the production line of the product 13. As shown in Fig. 1 the measuring device 15 is arranged close to the extrusion die 12 of the multi-component extruder 10.

This allows the use of the measuring values for generating regulating signals for the manufacturing process. In the event of deviations from the target values measured by the measuring device 15 the control device 16 will provide an appropriate regulating signal to the extruders 11 a, 11 b, 11 c of the multi-component extruder 10.

### List of Reference Signs

- 10: multi-component extruder
- 11: individual extruder
- 12: die
- 13: product
- 14: conveyor belt
- 15: measuring device
- 16: control device
- 17: NMR-sensor
- 18: spectrometer
- 19: computer
- 20: display
- 21: conveyor belt
- 22: conveyor belt
- 23: layer
- 24: sliding plate
- 25: permanent magnet
- 25a, 25b: magnet pole
- 26: shim unit
- 27: geometrical deviation
- 28: gap
- 29: coil
- 32 to 49: method steps
- 50: lower surface of product
- 51: arrow
- 52: arrow
- 53: product flow

## Claims

1. Method for controlling the production of a moving multi-component product (13) exiting from a manufacturing apparatus in a moving direction (53) defining an x-axis, the moving product (13) being made of an elastomeric material and having layers (23a, 23b, 23c) stacked on each other in a y-axis being perpendicular to the x-axis, wherein each layer (23a, 23b, 23c) has a thickness, said method comprising:
a) performing an NMR measurement of the moving product (13) by positioning a measuring device (15) below the moving product (13), the measuring device (15) including an NMR-sensor (17) comprising a temperature resistant permanent magnet (25) and providing a magnetic field B₀ with a substantially constant gradient Go in the y-axis;
b) determining the thickness of each of the layers (23a, 23b, 23c) based on the NMR measurement;
c) adjusting at least one operating parameter of said manufacturing apparatus based on the thickness of each of the layers (23a, 23b, 23c) determined in step b).

2. Method according to claim 1, said method comprising the steps of exciting the product (13) with pulse sequences, measuring echo signals of the pulse sequences and determining the thickness of each of the layers (23a, 23b, 23c) by evaluation of the echo signals.

3. Method according to claim 1 or claim 2, wherein in step a) a reference interface (50) between the NMR sensor (17) and an outside lower surface of the product (13) and the position of further interfaces of the layers (23a, 23b, 23c) of the moving product (13) are determined in relation to the reference interface (50) and wherein in step b) the thickness of each of the layers (23a,23b, 23c) is evaluated by determining differences between consecutive interface positions, each of said differences being equal to the thickness of the respective layer between said consecutive interface positions.

4. Method according to claim 2, wherein a CPMG sequence is applied to the product (13) by means of the NMR-sensor (17).

5. Method according to claim 3, wherein a half height method between two different layers (23a, 23b, 23c) is used to determine an interface between two consecutive different layers (23a, 23b, 23c), wherein a position is searched having an amplitude (a1 +a2)/2 wherein a1,a2 are amplitudes corresponding to spin-density images or weighted-T₂ images of the two consecutive different layers, respectively, and wherein, each of said spin-density images and T₂-weighted images is calculated from echoes acquired by means of a multi-echo pulse sequence.

6. Method according to any preceding claim, wherein the measuring is carried out at different lateral positions of the product (13).

7. Method according to claim 3, wherein the material of each of the layers (23a, 23b, 23c) is determined by the steps of defining a respective layer of substantially constant magnetic properties between any two consecutive interfaces;
determining a spin-density image and a T₂-weighted image for each of said layers from echoes acquired by means of a multi-echo pulse sequence;
determining, for each of said layers, averaged values of said spin-density image and said T₂-weighted image, respectively; and
determining the material by comparing said average values with a library of material properties.

8. Apparatus for the production of a moving multi-component product exiting from the apparatus in a moving direction (53) defining an x-axis (13), the moving multi-component product being made of an elastomeric material and having layers (23a, 23b, 23c) stacked on each other in a y-axis being perpendicular to the x-axis, wherein each layer (23a, 23b, 23c) has a different thickness, said apparatus comprising:
a) an output (12) for the product (13);
b) a measuring device (15) comprising an NMR-sensor (17) arranged to generate NMR-signals located close after the output (12) and below said product (13) during use;
c) the NMR-sensor (17) comprising a temperature resistant permanent magnet (25) and providing a defined magnetic field B₀ with a substantially constant gradient Go in the y-axis; and
d) the measuring device (15) being arranged to determine the thickness of each of the layers (23a, 23b, 23c) based on said NMR signals.

9. Apparatus according to claim 8, wherein magnetic poles (25a, 25b) of the permanent magnet (25) are distanced apart from each other, and a radio frequency coil (29) is arranged between the magnet poles (25a, 25b) of the permanent magnet (25).

10. Apparatus according to claim 9, **characterised in that** shim units (26) are arranged between the magnet poles (25a, 25b) of the permanent magnet (25) in order to provide said magnetic field with a substantially constant gradient Go in the y-axis and a substantially constant magnetic field B₀ in a z-x-plane parallel to the layers (231, 23b, 23c).

11. Apparatus according to claim 9 or 10, **characterised in that** the permanent magnet (25) and the shim units (26) are made of a samarium cobalt alloy.

12. Apparatus according to any one of claims 8 to 11, **characterised in that** a sliding plate (24) is provided at the top side of the NMR-sensor (17) for supporting the moving product (13).

13. Apparatus according to any one of claims 8 to 12, that a control device (16) is adapted to control the apparatus for the production of the moving product (13) based on the thickness of each of the layers.

14. Apparatus according to any one of claims 8 to 13, **characterised in that** a multi-component extruder comprising individual extruders (11 a,11 b,11 c) is provided as the output (12) for the product.

## Patentansprüche

1. Verfahren zum Steuern der Produktion eines sich bewegenden Multikomponentenprodukts (13), das eine Fertigungsvorrichtung in einer Bewegungsrichtung (53), die eine X-Achse definiert, verlässt, wobei das sich bewegende Produkt (13) aus einem elastomerem Material hergestellt ist und Schichten (23a, 23b, 23c) aufweist, die in einer Y-Achse, die senkrecht zu der X-Achse ist, aufeinander gestapelt sind, wobei jede Schicht (23a, 23b, 23c) eine Dicke aufweist, wobei das Verfahren umfasst:
a) Durchführen einer NMR-Messung des sich bewegenden Produkts (13) durch Positionieren einer Messvorrichtung (15) unterhalb des sich bewegenden Produkts (13), wobei die Messvorrichtung (15) einen NMR-Sensor (17) aufweist, der einen temperaturresistenten Permanentmagneten (25) umfasst und ein Magnetfeld B₀ mit einem im Wesentlichen konstanten Gradienten G₀ in der Y-Achse bereitstellt;
b) Bestimmen der Dicke jede der Schichten (23a, 23b, 23c) auf Grundlage der NMR-Messung;
c) Anpassen wenigstens eines Betriebsparameters der Fertigungsvorrichtung auf Grundlage der Dicke jeder der Schichten (23a, 23b, 23c), die in Schritt b) bestimmt wurde.

2. Verfahren nach Anspruch 1, wobei das Verfahren die Schritte des Anregens des Produkts (13) mit Pulssequenzen, des Messens von Echosignalen der Pulssequenzen und des Bestimmens der Dicke jeder der Schichten (23a, 23b, 23c) durch Evaluation der Echosignale umfasst.

3. Verfahren nach Anspruch 1 oder 2, wobei in Schritt a) eine Referenzfläche (50) zwischen dem NMR-Sensor (70) und einer äußeren unteren Fläche des Produkts (13) sowie die Position von weiteren Flächen der Schichten (23a, 23b, 23c) des sich bewegenden Produkts (13) in Relation zu der Referenzfläche (50) bestimmt werden, und wobei in Schritt b) die Dicke jeder der Schichten (23a, 23b, 23c) durch Bestimmen von Unterschieden zwischen aufeinander folgenden Flächenpositionen evaluiert wird, wobei jede der Unterschiede gleich der Dicke der jeweiligen Lage zwischen den aufeinander folgenden Flächenpositionen ist.

4. Verfahren nach Anspruch 2, wobei eine CPMG-Sequenz mittels des NMR-Sensors (17) auf das Produkt (13) einwirkt.

5. Verfahren nach Anspruch 3, wobei ein Halbehöheverfahren zwischen zwei Schichten (23a, 23b, 23c) verwendet wird, um eine Fläche zwischen zwei aufeinanderfolgenden unterschiedlichen Schichten (23a, 23b, 23c) zu bestimmen, wobei eine Position mit einer Amplitude (a1 + a2)/2 gesucht wird, wobei a1 und a2 Amplituden sind, die Spindichtebilder oder T₂-gewichtete Bilder von zwei aufeinanderfolgenden unterschiedlichen Schichten entsprechen, und wobei jedes der Spindichtebilder und der T₂-gewichteten Bilder aufgrund von Echos berechnet werden, die mittels Multiechopulssequenzen ermittelt werden.

6. Verfahren nach einem der voranstehenden Ansprüche, wobei die Messung an verschiedenen lateralen Positionen des Produkts (13) durchgeführt wird.

7. Verfahren nach Anspruch 3, wobei das Material jeder der Schichten (23a, 23b, 23c) durch die Schritte bestimmt wird:
Definieren einer jeweiligen Schicht von im Wesentlichen konstanten magnetischen Eigenschaften zwischen beliebigen zwei aufeinanderfolgenden Flächen;
Bestimmen eines Spindichtebildes oder eines T₂-gewichteten Bildes für jede der Schichten aufgrund von Echos, die mittels Multiechopulssequenzen erzielt werden;
Bestimmen von Durchschnittswerten des Spindichtebildes und des T₂-gewichteten Bildes für jede der Schichten;
Bestimmen des Materials durch Vergleichen der Durchschnittswerte mit einer Bibliothek von Materialeigenschaften.

8. Vorrichtung für die Produktion eines sich bewegenden Multikomponentenprodukts, das die Vorrichtung in einer Bewegungsrichtung (53), die eine X-Achse (13) definiert, verlässt, wobei das sich bewegende Multikomponentenprodukt aus einem elastomerischen Material hergestellt ist und Schichten (23a, 23b, 23c), die aufeinander in einer Y-Achse, die senkrecht zu der X-Achse ist, gestapelt sind, aufweist, wobei jede Schicht (23a, 23b, 23c) eine unterschiedliche Dicke hat, wobei die Vorrichtung umfasst:
a) eine Ausgabe (12) für das Produkt (13);
b) eine Messvorrichtung (50), die einen NMR-Sensor (17) aufweist, der angeordnet ist, NMR-Signale zu erzeugen, und der nahe nach der Ausgabe (12) und unterhalb des Produkts (13) während der Verwendung angeordnet ist;
c) wobei der NMR-Sensor (17) einen temperaturresistenten Permanentmagneten (25) aufweist, wobei der NMR-Sensor (17) ein definiertes magnetisches Feld B₀ mit einem wesentlich konstanten Gradienten G₀ in der Y-Achse bereitstellt; und
d) wobei die Messvorrichtung (15) angeordnet ist, die Dicke jeder der Schichten (23a, 23b, 23c) auf Grundlage des NMR-Signals zu bestimmen.

9. Vorrichtung nach Anspruch 8, wobei Magnetpole (25a, 25b) des Permanentmagneten (25) voneinander beabstandet sind und eine Radiofrequenzspule (29) zwischen den Magnetpolen (25a, 25b) der Permanentmagneten (25) angeordnet ist.

10. Vorrichtung nach Anspruch 9, **dadurch gekennzeichnet, dass** Shim-Einheiten (26) zwischen den Magnetpolen (25a, 25b) Permanentmagneten (25) angeordnet sind, um das Magnetfeld mit einem wesentlichen konstanten Gradienten G₀ in der Y-Achse und ein wesentliches konstantes Magnetfeld B₀ in einer Z-X-Ebene, die parallel zu den Schichten (23a, 23b, 23c) bereitzustellen.

11. Vorrichtung nach Anspruch 9 oder 10, **dadurch gekennzeichnet, dass** der Permanentmagnet (25) und die Shim-Einheiten (26) aus einer Samarium-Legierung hergestellt sind.

12. Vorrichtung nach einem der Ansprüche 8 bis 11, **dadurch gekennzeichnet, dass** eine Gleitplatte (24) an der Oberseite des NMR-Sensors (17) zum Stützen des sich bewegenden Produkts (13) vorgesehen ist.

13. Vorrichtung nach einem der Ansprüche 8 bis 12, **dadurch kennzeichnet dass**, eine Steuervorrichtung (16), angepasst ist, die Vorrichtung für die Produktion des sich bewegenden Produkts (13) auf Grundlage der Dicke jeder der Schichten zu steuern.

14. Vorrichtung nach einem der Ansprüche 8 bis 13, **dadurch gekennzeichnet, dass** ein Multikomponentenextruder, der einzelne Extruder auf (11 a, 11 b, 11 c) umfasst, als die Ausgabe (12) für das Produkt vorgesehen ist.

## Revendications

1. Procédé de commande de la production d'un produit multicomposant (13) en déplacement sortant d'un dispositif de fabrication dans une direction de déplacement (53) définissant un axe x, le produit (13) en déplacement étant constitué d'un matériau élastomère et présentant des couches (23a, 23b, 23c) empilées les unes sur les autres selon un axe y perpendiculaire à l'axe x, chaque couche (23a, 23b, 23c) présentant une épaisseur, ledit procédé comprenant :
a) réaliser une mesure RMN du produit (13) en déplacement en positionnant un dispositif de mesure (15) sous le produit (13) en déplacement, le dispositif de mesure (15) incluant un capteur RMN (17) comprenant un aimant permanent (25) résistant à la température et générant un champ magnétique B₀ avec un gradient G₀ sensiblement constant selon l'axe y ;
b) déterminer l'épaisseur de chacune des couches (23a, 23b, 23c) à partir de la mesure RMN ;
c) ajuster au moins un paramètre de fonctionnement dudit dispositif de fabrication en fonction de l'épaisseur de chacune des couches (23a, 23b, 23c) déterminée dans l'étape b).

2. Procédé selon la revendication 1, ledit procédé comprenant les étapes d'exciter le produit (13) avec des séquences d'impulsions, mesurer des signaux d'écho des séquences d'impulsions, et déterminer l'épaisseur de chacune des couches (23a, 23b, 23c) par une évaluation des signaux d'écho.

3. Procédé selon la revendication 1 ou la revendication 2, dans lequel, dans l'étape a), on détermine d'une part une interface de référence (50) entre le capteur RMN (17) et une surface inférieure externe du produit (13), et d'autre part la position d'autres interfaces des couches (23a, 23b, 23c) du produit (13) en déplacement par rapport à l'interface de référence (50), et dans lequel, dans l'étape b), on évalue l'épaisseur de chacune des couches (23a, 23b, 23c) en déterminant des différences entre des positions d'interfaces consécutives, chacune desdites différences étant égale à l'épaisseur de la couche respective entre lesdites positions d'interfaces consécutives.

4. Procédé selon la revendication 2, dans lequel une séquence CPMG est appliquée au produit (13) au moyen du capteur RMN (17).

5. Procédé selon la revendication 3, dans lequel une méthode de mi-hauteur entre deux couches différentes (23a, 23b, 23c) est utilisée pour déterminer une interface entre deux couches différentes consécutives (23a, 23b, 23c), une position présentant une amplitude (a1 + a2)/2 étant recherchée, où a1, a2 sont des amplitudes correspondant à des images de densité de spins ou des images pondérées en T₂ des deux couches différentes consécutives, respectivement, chacune desdites images de densité de spins et desdites images pondérées en T₂ étant calculée à partir d'échos acquis au moyen d'une séquence d'impulsions multi-écho.

6. Procédé selon l'une des revendications précédentes, dans lequel la mesure est réalisée à différentes positions latérales du produit (13).

7. Procédé selon la revendication 3, dans lequel le matériau de chacune des couches (23a, 23b, 23c) est déterminé par les étapes de
définir une couche respective aux propriétés magnétiques sensiblement constantes entre deux interfaces consécutives quelconques ;
déterminer une image de densité de spins et une image pondérée en T₂ pour chacune desdites couches à partir d'échos acquis au moyen d'une séquence d'impulsions multi-écho ;
déterminer, pour chacune desdites couches, des valeurs moyennes de ladite image de densité de spins et de ladite image pondérée en T₂, respectivement ; et
déterminer le matériau par comparaison desdites valeurs moyennes avec une bibliothèque de propriétés de matériaux.

8. Dispositif de production d'un produit multicomposant (13) en déplacement sortant du dispositif dans une direction de déplacement (53) définissant un axe x, le produit multicomposant (13) en déplacement étant constitué d'un matériau élastomère et présentant des couches (23a, 23b, 23c) empilées les unes sur les autres selon un axe y perpendiculaire à l'axe x, chaque couche (23a, 23b, 23c) présentant une épaisseur différente, ledit dispositif comprenant :
a) une sortie (12) pour le produit (13) ;
b) un dispositif de mesure (15) comprenant un capteur RMN (17) agencé pour générer des signaux RMN, situé à proximité aval de la sortie (12), et sous ledit produit (13) en utilisation ;
c) le capteur RMN (17) comprenant un aimant permanent (25) résistant à la température et générant un champ magnétique défini B₀ avec un gradient G₀ sensiblement constant selon l'axe y ; et
d) le dispositif de mesure (15) étant agencé pour déterminer l'épaisseur de chacune des couches (23a, 23b, 23c) à partir desdits signaux RMN.

9. Dispositif selon la revendication 8, dans lequel les pôles magnétiques (25a, 25b) de l'aimant permanent (25) sont distants l'un de l'autre, une bobine radiofréquence (29) étant disposée entre les pôles magnétiques (25a, 25b) de l'aimant permanent (25).

10. Dispositif selon la revendication 9, **caractérisé en ce que** des unités de correction (26) sont disposées entre les pôles magnétiques (25a, 25b) de l'aimant permanent (25) de manière à fournir ledit champ magnétique avec un gradient G₀ sensiblement constant selon l'axe y et un champ magnétique B₀ sensiblement constant dans un plan z-x parallèle aux couches (23a, 23b, 23c).

11. Dispositif selon la revendication 9 ou 10, **caractérisé en ce que** l'aimant permanent (25) et les unités de correction (26) sont réalisés en un alliage samarium-cobalt.

12. Dispositif selon l'une quelconque des revendications 8 à 11, **caractérisé en ce qu'**une plaque de glissement (24) est disposée sur la face supérieure du capteur RMN (17) pour supporter le produit (13) en déplacement.

13. Dispositif selon l'une quelconque des revendications 8 à 12, **caractérisé en ce qu'**un dispositif de commande (16) est agencé pour commander le dispositif de production du produit (13) en déplacement en fonction de l'épaisseur de chacune des couches.

14. Dispositif selon l'une quelconque des revendications 8 à 13, **caractérisé en ce qu'**une machine d'extrusion multicomposant comprenant des extrudeuses individuelles (11a, 11b, 11c) est disposée de manière à former la sortie (12) pour le produit.
